# EUROPEAN PATENT SPECIFICATION

(11) **EP 4 700 829 B1**
(45) Date of publication and mention of the grant of the patent: **02.12.2026**
(21) Application number: 25158715.0
(22) Date of filing: 19.02.2025
(51) Int. Cl.: H10W 72/20

(54) **PHOTONIC CHIP INCLUDING ELECTRICAL INTERCONNECTIONS WITH A DUAL-LOBED PILLAR**
PHOTONISCHER CHIP MIT ELEKTRISCHEN VERBINDUNGEN MIT EINER DOPPELLOBALEN SÄULE
PUCE PHOTONIQUE COMPRENANT DES INTERCONNEXIONS ÉLECTRIQUES À PILIER À DEUX LOBES

(30) Priority: 23.08.2024 US 202418813167
(43) Date of publication of application: 25.02.2026
(73) Proprietor: GlobalFoundries U.S. Inc., Malta, NY 12020 (US)
(72) Inventor: Machani, Kashi Vishwanath, 01109 Derseden (DE); Pozder, Scott, Malta, 12020 (US); Jiang, Yunyao, Malta, 12020 (US); Küchenmeister, Frank, 01109 Dresden (DE); Yarbrough, Willie James, Malta, 12020 (US); Cho, Jae Kyu, Malta, 12020 (US)
(74) Representative: Grünecker Patent- und Rechtsanwälte PartG mbB

(56) References cited:
- US-A1- 2015 130 051
- US-A1- 2020 105 702
- US-A1- 2021 035 938

## Description

### BACKGROUND

The present disclosure relates generally to semiconductor devices and integrated circuit fabrication and, more specifically, to structures for a photonic chip and associated methods.

Photonic chips are used in many applications and systems including, but not limited to, data communication systems and data computation systems. A photonic chip includes a photonic integrated circuit comprised of photonic components, such as modulators, polarizers, and optical couplers, that are used to manipulate light received from a light source, such as an optical fiber or a laser.

A photonic chip may be mounted on a laminate substrate to create a package assembly. Copper pillars or bumps may provide electrical interconnections between the laminate substrate and photonic chip. However, the copper bumps may cause failures in underlying portions of the back-end-of-line stack of the photonic chip due to strain transferred from stressed copper bumps to the interlayer dielectric layers of the back-end-of-line stack.

Document US 2021/0035938 A1 discloses bump-on-trace structures including metal bumps having recess regions. The recess regions provide space for solder displaced during reflow and thereby reduce solder protrusion and the risk of shorting between a metal bump and a neighboring metal trace. In certain embodiments, a metal bump includes end sections separated by a reduced-width middle section.

Document US 2015/0130051 A1 discloses bump-on-trace package structures in which metal bumps of one package component are bonded by solder regions to metal traces of another package component. The metal bumps may have elongated or other top-view shapes. Assembly yield may be improved by selecting relationships between the solder volume, the metal-trace width, and the metal-bump width.

Improved structures for a photonic chip, and associated methods, are needed.

### SUMMARY

In an embodiment, a structure in accordance with independent claim 1 is provided. Advantageous examples are defined in the dependent claims 2 to 13.

In another embodiment, a method in accordance with independent claim 14 is provided.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals are used to indicate like features in the various views.
FIG. 1 is a cross-sectional view of a package assembly in accordance with an embodiment of the invention.
FIG. 2 is an enlarged view of a portion of FIG. 1.
FIG. 3 is a top view of a portion of an electrical interconnection between the photonic chip and the laminate substrate of the package assembly of FIG. 1 before attachment of the laminate substrate to the photonic chip.
FIG. 4 is a cross-sectional view taken generally along line 4-4 in FIG. 3.
FIG. 5 is a top view of an electrical interconnection between the photonic chip and the laminate substrate of the package assembly in accordance with an alternative embodiment of the invention.
FIG. 5A is a cross-sectional view taken generally along line 5A-5A in FIG. 5.
FIG. 6 is a top view of an electrical interconnection between the photonic chip and the laminate substrate of the package assembly in accordance with an alternative embodiment of the invention.
FIG. 7 is a cross-sectional view of an electrical interconnection between the photonic chip and the laminate substrate of the package assembly in accordance with an alternative embodiment of the invention.
FIG. 8 is a cross-sectional view of an electrical interconnection between the photonic chip and the laminate substrate of the package assembly in accordance with an alternative embodiment of the invention.

### DETAILED DESCRIPTION

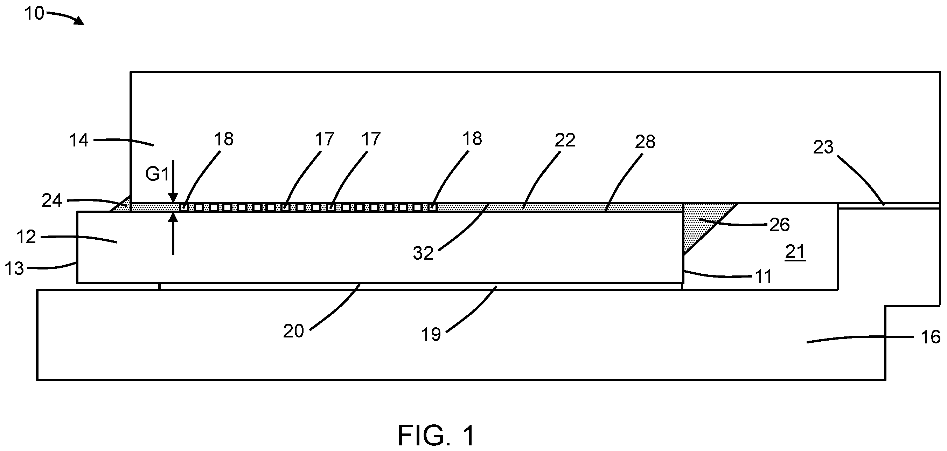

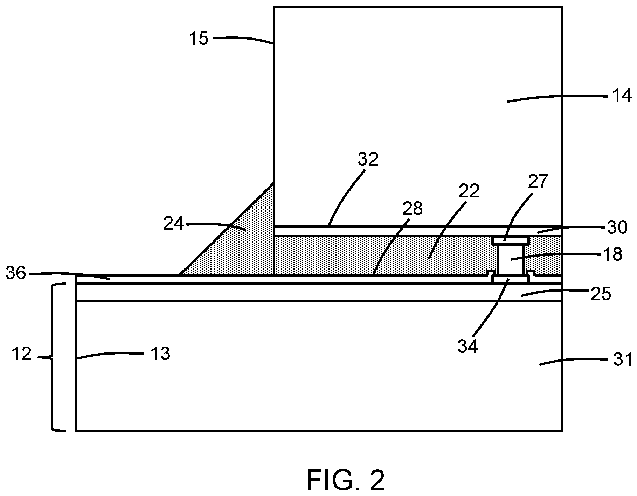

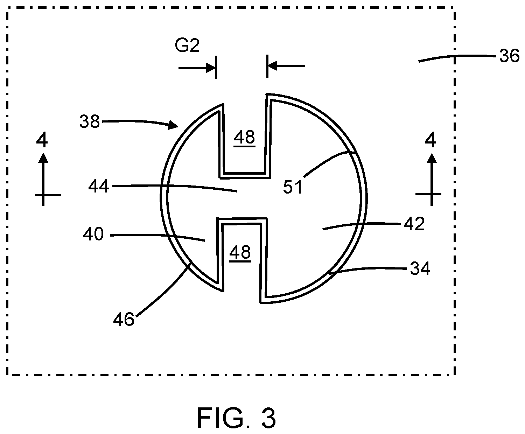

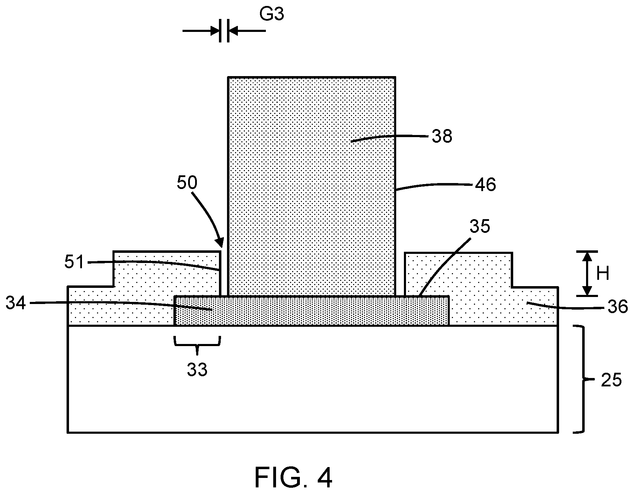

With reference to FIGS. 1, 2, 3, 4 and in accordance with embodiments of the invention, a structure 10 for a lidded package assembly includes a photonic chip 12, a laminate substrate 14 that provides a representative packaging substrate, and a lid 16. The photonic chip 12 is disposed between the laminate substrate 14 and the lid 16. The laminate substrate 14 may include an epoxy-glass cloth core and alternating layers of metal and electrical insulator that are laminated to the core. In an embodiment, the laminate substrate 14 may include layers of a copper film that alternate with layers of an insulating resin, such as Ajinomoto Build-up Film (ABF). A build-up of the alternating layers of the laminate substrate 14 may be disposed adjacent to the photonic chip 12.

The photonic chip 12 includes photonic components, such as modulators, polarizers, and optical couplers, arranged in a functional photonic integrated circuit that is configured to manipulate light received from a light source, such as an optical fiber or a laser. The photonic chip 12 includes a substrate 31 on which the photonic integrated circuit is disposed and a back-end-of-line stack 25 disposed on the substrate 31. The substrate 31 may be comprised of, for example, silicon. The back-end-of-line stack 25, which may include bond pads 34, a set of interlayer dielectric layers, and interconnects in the interlayer dielectric layers, may be disposed adjacent to the laminate substrate 14. Each interlayer dielectric layer may be comprised of a dielectric material, such as a low-k dielectric material, silicon nitride, or silicon dioxide, and the interconnects may be comprised of a metal, such as aluminum or copper.

A dielectric layer 36 comprised of an inorganic dielectric material, such as silicon dioxide formed using tetraethyl orthosilicate, may be formed as a passivation layer on the surface of the back-end-of-line stack 25 at which the bond pads 34 are exposed. In an embodiment, the dielectric layer 36 may have a thickness on the order of six (6) micrometers. The inorganic dielectric material constituting the dielectric layer 36 may be characterized by a high stiffness and a low coefficient of thermal expansion, particularly in comparison to an organic material such as polyimide.

The laminate substrate 14 includes bond pads 27 that are coupled by vias to the metal layers in the build-up. A surface 32 of the laminate substrate 14, which is adjacent to a top surface 28 of the back-end-of-line stack 25 of the photonic chip 12, may be coated by a solder mask layer 30 that is coterminous with an edge 15 of the laminate substrate 14. Electrical interconnections 17, 18 couple the bond pads 34 of the photonic chip 12 to the bond pads 27 of the laminate substrate 14. The electrical interconnections 17, 18 are arranged in a gap G1 between the top surface 28 of the back-end-of-line stack 25 and the surface 32 of the laminate substrate 14. One of the electrical interconnections 18 may be located adjacent to the entrance to the gap G1 nearest to the side surface 13 of the photonic chip 12. The other of the electrical interconnections 18 may be located adjacent to the entrance to the gap G1 nearest the side surface 11 of the photonic chip 12. All of the electrical interconnections 17 may be arranged between the electrical interconnections 18 that are located at the entrances at the opposite sides of the gap G1.

The photonic chip 12 also includes a bottom surface 20 that is opposite to the top surface 28, a side surface 11, and a side surface 13 that is opposite to the side surface 11. The side surfaces 11, 13 are connected by the bottom surface 20 and the top surface 28. The photonic chip 12 includes a portion that is disposed between the side surface 13 and the edge 15 of the laminate substrate 14 due to a lateral offset in the attachment of the photonic chip 12 to the laminate substrate 14. The side surface 11 is overlapped by the laminate substrate 14, and the side surface 13 is not overlapped by the laminate substrate 14.

The lid 16, which may be comprised of an electrically-conductive and thermally-conductive material, such as nickel-coated copper, is attached to the same side of the laminate substrate 14 as the photonic chip 12. The photonic chip 12 overlaps with a portion of the lid 16. A layer 19 of thermal interface material may be disposed between the photonic chip 12 and the overlapped portion of the lid 16. The thermal interface material in the layer 19 may be comprised of, for example, a thermal adhesive or a thermal grease that functions to improve heat flow between the photonic chip 12 and the overlapped portion of the lid 16.

Another portion of the lid 16 may be attached to a portion of the surface 32 of the laminate substrate 14 by an adhesive layer 23. An open space 21 is disposed between the side surface 11 of the photonic chip 12, the lid 16, and a portion of the surface 32 of the laminate substrate 14. The different portions of the lid 16 are characterized by a vertical offset that accommodates the placement of the photonic chip 12 between the laminate substrate 14 and the lid 16. The attachment of the portion of the lid 16 to the laminate substrate 14 adds mechanical strength to the structure 10 and, if the adhesive constituting the adhesive layer 23 is conductive, may provide a conductive path from the lid 16 to the laminate substrate 14.

A layer 22 comprised of an underfill material may be disposed in the gap G1 between the photonic chip 12 and the laminate substrate 14 that includes the electrical interconnections 17, 18. The layer 22 may have a thickness that is substantially equal to the height dimension of the gap G1. The layer 22 protects the electrical interconnections 17, 18 against various adverse environmental factors, redistributes mechanical stresses due to shock, and prevents the electrical interconnections 17, 18 from moving under strain during thermal cycles when the photonic chip 12 is operating.

A fillet 24 comprised of an underfill material is disposed on a portion of the top surface 28 of the photonic chip 12 adjacent to the edge 15 of the laminate substrate 14 and adjacent to the gap G1. A fillet 26 comprised of an underfill material is disposed on a portion of the side surface 11 of the photonic chip 12 adjacent to the surface 32 of the laminate substrate 14 and adjacent to the gap G1.

At least one electrical interconnection 18 includes a pillar 38 that is positioned on one of the bond pads 34 of the photonic chip 12. In an embodiment, the pillar 38 may be positioned directly on a central portion of a top surface 35 of the bond pad 34. In an embodiment, the top surface 35 of the bond pad 34 may be planar. The pillar 38 may be comprised of a metal, such as copper, and may be capped by one or more capping layers comprised of solder or a barrier layer comprised of nickel or another metal. The pillar 38 may be formed by a plating process.

The pillar 38 has, in a top view thereof, a dual-lobed shape that includes a lobed section 40, a lobed section 42 spaced from the lobed section 40 by a gap G2, a connecting section 44 that connects a portion of the lobed section 40 to a portion of the lobed section 42, and an outer sidewall 46 that traces the outer boundary of the lobed sections 40, 42 and the connecting section 44. In an embodiment, the lobed section 40 includes a curved edge as a portion of the outer sidewall 46, the lobed section 42 includes a curved edge as a portion of the outer sidewall 46, and the connecting section 44 is connected to a portion of the lobed section 42 and a portion of the lobed section 40 that face each other across the gap G2.

The connecting section 44 provides a bridge that extends across the gap G2 between the lobed section 40 and the lobed section 42. The pillar 38 includes notches 48 in its outer sidewall 46 that may extend over the full height of the pillar 38 to the underlying bond pad 34. The notches 48, which are disposed between the lobed section 40 and the lobed section 42, represent portions of the gap G2 that are separated from each other by the connecting section 44. The connecting section 44 is laterally positioned between the notches 48.

The lobed section 40 and the lobed section 42 may have different sizes such that the pillar 38 is asymmetric. In an embodiment, the lobed section 40 may be smaller than the lobed section 42. In an embodiment, the pillar 38 may be rotationally oriented such that the lobed section 40 is closer to the side surface 13 of the photonic chip 12 than the lobed section 42 or closer to the side surface 11 of the photonic chip 12 than the lobed section 42.

The dielectric layer 36 includes an opening 50. The pillar 38 is positioned inside the opening 50, the pillar 38 has an outer sidewall 46, and the opening 50 has a sidewall 51 that is spaced from the outer sidewall 46 of the pillar 38 by a gap G3. The dielectric layer 36 overlaps with a portion 33 of the bond pad 34 that is adjacent to the sidewall 51 of the opening 50. The opening 50 may have a dual-lobed shape that matches and is slightly larger than the dual-lobed shape of the dual-lobed pillar 38. More specifically, an inner perimeter of the opening 50 may trace the outer sidewall 46 of the dual-lobed pillar 38 with an open space therebetween defining the gap G3, the opening 50 may have a lobed section along its inner perimeter that coincides in location with the lobed section 40, and the opening 50 may have a lobed section along its inner perimeter that coincides in location with the lobed section 42. The gap G3 extends downwardly between the sidewall 51 of the opening 50 and the outer sidewall 46 of the pillar 38 over the height H of the opening 50 to the top surface 35 of the bond pad 34 such that the dielectric layer 36 has a non-contacting and spaced-apart relationship with the pillar 38. In an embodiment, the opening 50 may have a section along its sidewall 51 that coincides in location with the connecting section 44 along the outer sidewall 46 of the pillar 38. In an embodiment, the sidewall 51 of the opening 50 may be oriented perpendicular to a horizontal plane established by the top surface 35 of the bond pad 34 such that the opening 50 is a right circular cylinder. In an embodiment, the gap G3 may have an average width dimension that is constant over the height H of the pillar 38. In an embodiment, the average width dimension of the gap G3 may be selected to optimize the associated benefit by reducing the strain transferred from the pillar 38 to the interlayer dielectric layers of the back-end-of-line stack 25. In an embodiment, the average width dimension of the gap G3 may be less than about 1 micrometer.

The dual-lobed shape of the pillar 38 and the shape of the opening 50, which may also be dual lobed, in the dielectric layer 36 may cooperate to significantly reduce the strain transferred from the pillar 38 to the back-end-of-line stack 25 of the photonic chip 12 and thereby reduce or eliminate the incidence of chip-package interaction failures in adjacent portions of the back-end-of-line stack 25. The dual-lobed shape of the pillar 38 may reduce the tensile pressure without increasing the area of the pillar 38 in contact with the bond pad 34. In particular, the tensile pressure may be reduced over the area of contact between the lobed section 40 of the pillar 38 and the bond pad 34. The rotational orientation of the pillar 38 that places the smaller lobed section 40 closer to either the nearby side surface 11 of the photonic chip 12 than the larger lobed section 42 or the nearby side surface 13 of the photonic chip 12 than the larger lobed section 42 may contribute to reducing the tensile pressure.

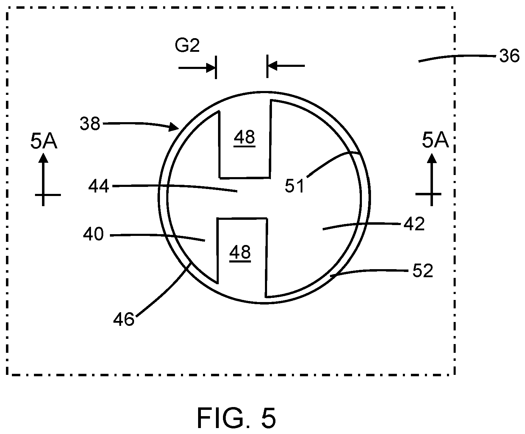

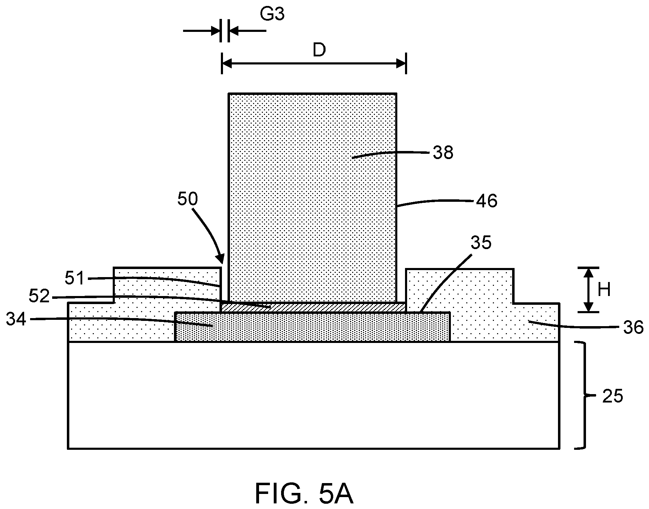

With reference to FIGS. 5, 5A and in accordance with an alternative embodiment, each electrical interconnection 18 may include a pedestal or base 52 that is positioned between the bond pad 34 and the pillar 38. In an embodiment as shown in FIG. 5, the base 52 may be cylindrical with a round cross-sectional profile that differs from the dual-lobed shape of the pillar 38. The notches 48 in the sidewall of the pillar 38 may extend over the full height of the pillar 38 to the base 52. The opening 50 may be modified to be cylindrical with a round cross-sectional profile, instead of dual-lobed, such that the opening 50 and the base 52 have equal diameters D. The gap G3 between the outer sidewall 46 of the pillar 38 and the sidewall 51 of the opening 50 may be preserved over at least the portions of the sidewall 51 of the opening 50 adjacent to the curved portions of the lobed sections 40, 42 of the pillar 38. In an embodiment, the base 52 may fully overlap with the bond pad 34 over the entirety of the gap G3.

In an embodiment, the base 52 and the pillar 38 may be comprised of the same metal. In an embodiment, the base 52 may be comprised of a different metal from the pillar 38. In an embodiment, the base 52 may be comprised of a different metal from the bond pad 34. The presence of the base 52 filling the gap G3 may replace at least a portion of underfill material that would otherwise fill the gap G3.

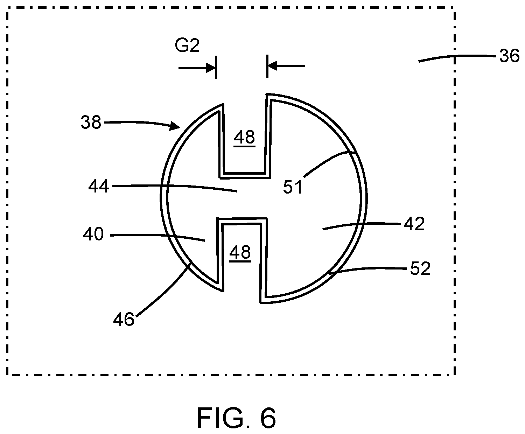

With reference to FIG. 6 and in accordance with an alternative embodiment, the base 52 may have a dual-lobed shape that mirrors the dual-lobed shape of the pillar 38, as well as the dual-lobed shape of the opening 50 in the dielectric layer 36. Specifically, the base 52 may have a lobed section that coincides in location with the lobed section 40 of the pillar 38, a lobed section that coincides in location with the lobed section 42 of the pillar 38, and a section that coincides in location with the connecting section 44 of the pillar 38.

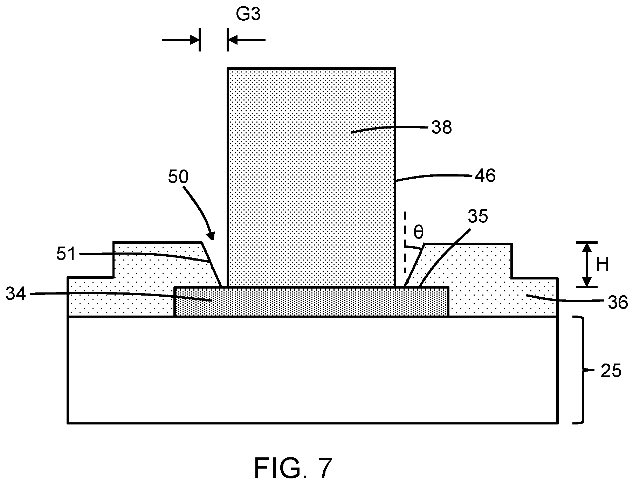

With reference to FIG. 7 and in accordance with an alternative embodiment, the sidewall 51 of the opening 50 in the dielectric layer 36 may be inclined outwardly at an acute angle that is a complementary angle to the angle θ. The angle θ may be evaluated relative to a surface normal perpendicular to a horizontal plane established by the top surface 35 of the bond pad 34. In an embodiment, the sidewall 51 of the opening 50, which is adjacent to the outer sidewall 46 of the pillar 38, may be inclined in a range of about 75° to less than 90° relative to a horizontal plane established by the top surface 35 of the bond pad 34. The width of the gap G3 may increase with increasing distance from the bond pad 34 over the height H of the opening 50.

The inclination of the sidewall 51 of the opening 50 in the dielectric layer 36, particularly with an inclination within a range of about 75° to less than 90°, may contribute to the further reduction of the strain transferred from the pillar 38 to the back-end-of-line stack 25 of the photonic chip 12. The further reduction in transferred strain may thereby further assist with reducing or eliminating the incidence of chip-package interaction failures in adjacent portions of the back-end-of-line stack 25.

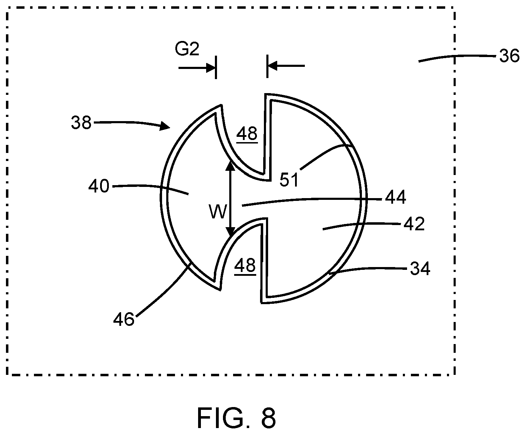

With reference to FIG. 8 and in accordance with an alternative embodiment, the connecting section 44 of the pillar 38 may connect at least a portion of the lobed section 40 of the pillar 38 to at least a portion of the lobed section 42 of the pillar 38. The connecting section 44 of the pillar 38 may be curved such that its width dimension W increases with increasing distance from the lobed section 42. The portion of the opening 50 bordering the connecting section 44 may also be curved to match the curvature of the connecting section 44 and to maintain the width dimension of the gap G3 between the sidewall 51 and the outer sidewall 46.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value or precise condition as specified. In embodiments, language of approximation may indicate a range of +/-10% of the stated value(s) or the stated condition(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction or plane in the frame of reference perpendicular to the horizontal plane, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features may "overlap" if a feature extends over, and covers a part of, another feature.

The descriptions of the various embodiments of the present invention have been presented for purposes of illustration but are not intended to be exhaustive or limited to the embodiments disclosed. The terminology used herein was chosen to best explain the principles of the embodiments, the practical application or technical improvement over technologies found in the marketplace, or to enable others of ordinary skill in the art to understand the embodiments disclosed herein.

## Claims

1. A structure (10), comprising:
a photonic chip (12) including a bond pad (34);
an electrical interconnection (18) including a pillar (38) positioned on a portion of the bond pad (34), the pillar (38) having, in a top view thereof, a first lobed section (40), a second lobed section (42) spaced from the first lobed section (40) by a first gap (G2), and a connecting section (44) extending across a portion of the first gap (G2) to connect the first lobed section (40) to the second lobed section (42); and **characterized by**
a dielectric layer (36) having an opening (50),
wherein the pillar (38) is positioned inside the opening (50), the pillar (38) has a sidewall (46), and the opening (50) has a sidewall (51) that is spaced from the sidewall (46) of the pillar (38) by a second gap (G3).

2. The structure (10) of claim 1, wherein the first lobed section (40) of the pillar (38) is smaller than the second lobed section (42) of the pillar (38).

3. The structure (10) of claim 1 or 2, wherein the dielectric layer (36) overlaps with a portion (33) of the bond pad (34) adjacent to the sidewall (51) of the opening (50), and/or
wherein the opening (50) has a height (H) relative to the bond pad (34), and the second gap (G3) has a width dimension that is constant over the height (H) of the opening (50).

4. The structure (10) of one of claims 1 to 3, wherein the second gap (G3) has an average width dimension that is less than about 1 micrometer, and/or
wherein the second gap (G3) has a width dimension that increases with increasing distance from the bond pad (34) over a height (H) of the opening (50).

5. The structure (10) of one of claims 1 to 4, wherein the bond pad (34) has a planar top surface (35), and the sidewall (51) of the opening (50) is inclined at an angle in a range of about 75° to less than 90° relative to the planar top surface (35) of the bond pad (34).

6. The structure (10) of one of claims 1 to 5, wherein the electrical interconnection (18) includes a base (52) positioned between the bond pad (34) and the pillar (38), the base (52) preferably being cylindrical with a round cross-sectional profile.

7. The structure (10) of claim 6, wherein the base (52) has a first lobed section that coincides with the first lobed section (40) of the pillar (38), a second lobed section that coincides in location with the second lobed section (42) of the pillar (38), and a section that coincides with the connecting section (44) of the pillar (38).

8. The structure (10) of one of claims 1 to 7, wherein the opening (50) has a first lobed section that coincides with the first lobed section (40) of the pillar (38), a second lobed section that coincides in location with the second lobed section (42) of the pillar (38), and a section that coincides with the connecting section (44) of the pillar (38), the second gap (G3) preferably having a width dimension that is constant between the opening (50) and the pillar (38).

9. The structure (10) of one of claims 1 to 8, wherein the dielectric layer (36) comprises an inorganic dielectric material, the dielectric layer (36) preferably having a thickness of about 6 micrometers.

10. The structure (10) of one of claims 1 to 9, wherein the sidewall (51) of the opening (50) fully surrounds the sidewall (46) of the pillar (38).

11. The structure (10) of one of claims 1 to 10, further comprising:
a laminate substrate (14) that is separated from the photonic chip (12) by a gap (G1),
wherein the bond pad (34) and the electrical interconnection (18) are disposed in the gap (G1).

12. The structure (10) of one of claims 1 to 11, wherein the photonic chip (12) has a side surface (11, 13), the first lobed section (40) is positioned closer to the side surface (11, 13) of the photonic chip (12) than the second lobed section (42), and the first lobed section (40) of the pillar (38) is smaller than the second lobed section (42) of the pillar (38).

13. The structure (10) of one of claims 1 to 12, wherein the first lobed section (40) of the pillar (38) is smaller than the second lobed section (42) of the pillar (38), and the connecting section (44) has a width dimension (W) that increases with increasing distance from the second lobed section (42) of the pillar (38).

14. A method comprising:
forming a photonic chip (12) including a bond pad (34);
forming an electrical interconnection (18) that includes a pillar (38) positioned on a portion of the bond pad (34), wherein the pillar (38) has, in a top view thereof, a first lobed section (40), a second lobed section (42) spaced from the first lobed section (40) by a gap (G2), and a connecting section (44) extending across a portion of the gap (G2) to connect the first lobed section (40) to the second lobed section (42); and
forming a dielectric layer (36) having an opening (50),
wherein the pillar (38) is positioned inside the opening (50), the pillar (38) has a sidewall (46), and the opening (50) has a sidewall (51) that is spaced from the sidewall (46) of the pillar (38) by a second gap (G3).

## Patentansprüche

1. Struktur (10), umfassend:
einen photonischen Chip (12), der ein Bondpad (34) aufweist;
eine elektrische Verbindung (18), die eine Säule (38) aufweist, die auf einem Teilbereich des Bondpads (34) angeordnet ist, wobei die Säule (38) in einer Draufsicht auf die Säule (38) einen ersten lappenförmigen Abschnitt (40), einen zweiten lappenförmigen Abschnitt (42), der durch einen ersten Spalt (G2) von dem ersten lappenförmigen Abschnitt (40) beabstandet ist, und einen Verbindungsabschnitt (44) aufweist, der sich über einen Teilbereich des ersten Spalts (G2) erstreckt, um den ersten lappenförmigen Abschnitt (40) mit dem zweiten lappenförmigen Abschnitt (42) zu verbinden; und
**gekennzeichnet durch**
eine dielektrische Schicht (36), die eine Öffnung (50) aufweist,
wobei die Säule (38) innerhalb der Öffnung (50) angeordnet ist, die Säule (38) eine Seitenwand (46) aufweist und die Öffnung (50) eine Seitenwand (51) aufweist, die durch einen zweiten Spalt (G3) von der Seitenwand (46) der Säule (38) beabstandet ist.

2. Struktur (10) nach Anspruch 1, wobei der erste lappenförmige Abschnitt (40) der Säule (38) kleiner ist als der zweite lappenförmige Abschnitt (42) der Säule (38).

3. Struktur (10) nach Anspruch 1 oder 2, wobei die dielektrische Schicht (36) einen Teilbereich (33) des Bondpads (34) angrenzend an die Seitenwand (51) der Öffnung (50) überlappt und/oder
wobei die Öffnung (50) eine Höhe (H) bezogen auf das Bondpad (34) aufweist und der zweite Spalt (G3) eine Breitenabmessung aufweist, die über die Höhe (H) der Öffnung (50) konstant ist.

4. Struktur (10) nach einem der Ansprüche 1 bis 3, wobei der zweite Spalt (G3) eine mittlere Breitenabmessung aufweist, die weniger als etwa 1 Mikrometer beträgt, und/oder
wobei der zweite Spalt (G3) eine Breitenabmessung aufweist, die mit zunehmendem Abstand von dem Bondpad (34) über eine Höhe (H) der Öffnung (50) zunimmt.

5. Struktur (10) nach einem der Ansprüche 1 bis 4, wobei das Bondpad (34) eine ebene Oberseite (35) aufweist und die Seitenwand (51) der Öffnung (50) in einem Winkel in einem Bereich von etwa 75° bis weniger als 90° bezogen auf die ebene Oberseite (35) des Bondpads (34) geneigt ist.

6. Struktur (10) nach einem der Ansprüche 1 bis 5, wobei die elektrische Verbindung (18) einen Sockel (52) aufweist, der zwischen dem Bondpad (34) und der Säule (38) angeordnet ist, wobei der Sockel (52) vorzugsweise zylindrisch ist und ein rundes Querschnittsprofil aufweist.

7. Struktur (10) nach Anspruch 6, wobei der Sockel (52) einen ersten lappenförmigen Abschnitt aufweist, der mit dem ersten lappenförmigen Abschnitt (40) der Säule (38) übereinstimmt, einen zweiten lappenförmigen Abschnitt, der in seiner Position mit dem zweiten lappenförmigen Abschnitt (42) der Säule (38) übereinstimmt, und einen Abschnitt, der mit dem Verbindungsabschnitt (44) der Säule (38) übereinstimmt.

8. Struktur (10) nach einem der Ansprüche 1 bis 7, wobei die Öffnung (50) einen ersten lappenförmigen Abschnitt aufweist, der mit dem ersten lappenförmigen Abschnitt (40) der Säule (38) übereinstimmt, einen zweiten lappenförmigen Abschnitt, der in seiner Position mit dem zweiten lappenförmigen Abschnitt (42) der Säule (38) übereinstimmt, und einen Abschnitt, der mit dem Verbindungsabschnitt (44) der Säule (38) übereinstimmt, wobei der zweite Spalt (G3) vorzugsweise eine Breitenabmessung aufweist, die zwischen der Öffnung (50) und der Säule (38) konstant ist.

9. Struktur (10) nach einem der Ansprüche 1 bis 8, wobei die dielektrische Schicht (36) ein anorganisches dielektrisches Material umfasst, wobei die dielektrische Schicht (36) vorzugsweise eine Dicke von etwa 6 Mikrometern aufweist.

10. Struktur (10) nach einem der Ansprüche 1 bis 9, wobei die Seitenwand (51) der Öffnung (50) die Seitenwand (46) der Säule (38) vollständig umgibt.

11. Struktur (10) nach einem der Ansprüche 1 bis 10, ferner umfassend:
ein Laminatsubstrat (14), das durch einen Zwischenraum (G1) von dem photonischen Chip (12) getrennt ist,
wobei das Bondpad (34) und die elektrische Verbindung (18) in dem Zwischenraum (G1) angeordnet sind.

12. Struktur (10) nach einem der Ansprüche 1 bis 11, wobei der photonische Chip (12) eine Seitenfläche (11, 13) aufweist, der erste lappenförmige Abschnitt (40) näher an der Seitenfläche (11, 13) des photonischen Chips (12) angeordnet ist als der zweite lappenförmige Abschnitt (42) und der erste lappenförmige Abschnitt (40) der Säule (38) kleiner ist als der zweite lappenförmige Abschnitt (42) der Säule (38).

13. Struktur (10) nach einem der Ansprüche 1 bis 12, wobei der erste lappenförmige Abschnitt (40) der Säule (38) kleiner ist als der zweite lappenförmige Abschnitt (42) der Säule (38) und der Verbindungsabschnitt (44) eine Breitenabmessung (W) aufweist, die mit zunehmendem Abstand von dem zweiten lappenförmigen Abschnitt (42) der Säule (38) zunimmt.

14. Verfahren, umfassend:
Ausbilden eines photonischen Chips (12), der ein Bondpad (34) aufweist;
Ausbilden einer elektrischen Verbindung (18), die eine Säule (38) aufweist, die auf einem Teilbereich des Bondpads (34) angeordnet ist, wobei die Säule (38) in einer Draufsicht auf die Säule (38) einen ersten lappenförmigen Abschnitt (40), einen zweiten lappenförmigen Abschnitt (42), der durch einen Spalt (G2) von dem ersten lappenförmigen Abschnitt (40) beabstandet ist, und einen Verbindungsabschnitt (44) aufweist, der sich über einen Teilbereich des Spalts (G2) erstreckt, um den ersten lappenförmigen Abschnitt (40) mit dem zweiten lappenförmigen Abschnitt (42) zu verbinden; und
Ausbilden einer dielektrischen Schicht (36), die eine Öffnung (50) aufweist,
wobei die Säule (38) innerhalb der Öffnung (50) angeordnet ist, die Säule (38) eine Seitenwand (46) aufweist und die Öffnung (50) eine Seitenwand (51) aufweist, die durch einen zweiten Spalt (G3) von der Seitenwand (46) der Säule (38) beabstandet ist.

## Revendications

1. Structure (10), comprenant :
une puce photonique (12) comportant un plot de connexion (34) ;
une interconnexion électrique (18) comportant un pilier (38) disposé sur une portion du plot de connexion (34), le pilier (38) présentant, dans une vue de dessus de celui-ci, une première partie lobée (40), une deuxième partie lobée (42) espacée de la première partie lobée (40) par un premier espace (G2), et une partie de liaison (44) s'étendant à travers une portion du premier espace (G2) pour relier la première partie lobée (40) à la deuxième partie lobée (42) ; et **caractérisée par**
une couche diélectrique (36) présentant une ouverture (50),
dans laquelle le pilier (38) est disposé à l'intérieur de l'ouverture (50), le pilier (38) présente une paroi latérale (46) et l'ouverture (50) présente une paroi latérale (51) qui est espacée de la paroi latérale (46) du pilier (38) par un deuxième espace (G3).

2. Structure (10) selon la revendication 1, dans laquelle la première partie lobée (40) du pilier (38) est plus petite que la deuxième partie lobée (42) du pilier (38).

3. Structure (10) selon la revendication 1 ou 2, dans laquelle la couche diélectrique (36) chevauche une portion (33) du plot de connexion (34) adjacente à la paroi latérale (51) de l'ouverture (50), et/ou
dans laquelle l'ouverture (50) présente une hauteur (H) par rapport au plot de connexion (34), et le deuxième espace (G3) présente une dimension de largeur qui est constante sur la hauteur (H) de l'ouverture (50).

4. Structure (10) selon l'une des revendications 1 à 3, dans laquelle le deuxième espace (G3) présente une dimension de largeur moyenne qui est inférieure à environ 1 micromètre, et/ou
dans laquelle le deuxième espace (G3) présente une dimension de largeur qui augmente avec l'augmentation de la distance par rapport au plot de connexion (34) sur une hauteur (H) de l'ouverture (50).

5. Structure (10) selon l'une des revendications 1 à 4, dans laquelle le plot de connexion (34) présente une surface supérieure plane (35), et la paroi latérale (51) de l'ouverture (50) est inclinée selon un angle compris dans une plage allant d'environ 75° à moins de 90° par rapport à la surface supérieure plane (35) du plot de connexion (34).

6. Structure (10) selon l'une des revendications 1 à 5, dans laquelle l'interconnexion électrique (18) comporte une embase (52) disposée entre le plot de connexion (34) et le pilier (38), l'embase (52) étant de préférence cylindrique et présentant un profil de section transversale rond.

7. Structure (10) selon la revendication 6, dans laquelle l'embase (52) présente une première partie lobée qui coïncide avec la première partie lobée (40) du pilier (38), une deuxième partie lobée qui coïncide en position avec la deuxième partie lobée (42) du pilier (38), et une partie qui coïncide avec la partie de liaison (44) du pilier (38).

8. Structure (10) selon l'une des revendications 1 à 7, dans laquelle l'ouverture (50) présente une première partie lobée qui coïncide avec la première partie lobée (40) du pilier (38), une deuxième partie lobée qui coïncide en position avec la deuxième partie lobée (42) du pilier (38), et une partie qui coïncide avec la partie de liaison (44) du pilier (38), le deuxième espace (G3) présentant de préférence une dimension de largeur qui est constante entre l'ouverture (50) et le pilier (38).

9. Structure (10) selon l'une des revendications 1 à 8, dans laquelle la couche diélectrique (36) comprend un matériau diélectrique inorganique, la couche diélectrique (36) présentant de préférence une épaisseur d'environ 6 micromètres.

10. Structure (10) selon l'une des revendications 1 à 9, dans laquelle la paroi latérale (51) de l'ouverture (50) entoure complètement la paroi latérale (46) du pilier (38).

11. Structure (10) selon l'une des revendications 1 à 10, comprenant en outre :
un substrat stratifié (14) qui est séparé de la puce photonique (12) par un espace (G1),
dans laquelle le plot de connexion (34) et l'interconnexion électrique (18) sont disposés dans l'espace (G1).

12. Structure (10) selon l'une des revendications 1 à 11, dans laquelle la puce photonique (12) présente une surface latérale (11, 13), la première partie lobée (40) est disposée plus près de la surface latérale (11, 13) de la puce photonique (12) que la deuxième partie lobée (42), et la première partie lobée (40) du pilier (38) est plus petite que la deuxième partie lobée (42) du pilier (38).

13. Structure (10) selon l'une des revendications 1 à 12, dans laquelle la première partie lobée (40) du pilier (38) est plus petite que la deuxième partie lobée (42) du pilier (38), et la partie de liaison (44) présente une dimension de largeur (W) qui augmente avec l'augmentation de la distance par rapport à la deuxième partie lobée (42) du pilier (38).

14. Procédé comprenant :
la formation d'une puce photonique (12) comportant un plot de connexion (34) ;
la formation d'une interconnexion électrique (18) qui comporte un pilier (38) disposé sur une portion du plot de connexion (34), dans lequel le pilier (38) présente, dans une vue de dessus de celui-ci, une première partie lobée (40), une deuxième partie lobée (42) espacée de la première partie lobée (40) par un espace (G2), et une partie de liaison (44) s'étendant à travers une portion de l'espace (G2) pour relier la première partie lobée (40) à la deuxième partie lobée (42) ; et
la formation d'une couche diélectrique (36) présentant une ouverture (50),
dans lequel le pilier (38) est disposé à l'intérieur de l'ouverture (50), le pilier (38) présente une paroi latérale (46) et l'ouverture (50) présente une paroi latérale (51) qui est espacée de la paroi latérale (46) du pilier (38) par un deuxième espace (G3).
